# EUROPEAN PATENT APPLICATION

(11) **EP 4 383 993 A1**
(43) Date of publication of application: **12.06.2024**
(21) Application number: 22853121.6
(22) Date of filing: 03.08.2022
(51) Int. Cl.: H10N 15/20, C23C 14/14, H02N 11/00

(54) **THERMOELECTRIC CONVERSION ELEMENT**

(30) Priority: 06.08.2021 JP 2021130339
(71) Applicant: The University of Tokyo, Bunkyo-ku, Tokyo 113-8654 (JP); NITTO DENKO CORPORATION, Ibaraki-shi Osaka 567-8680 (JP)
(72) Inventor: NAKATSUJI, Satoru, Tokyo 113-8654 (JP); HIGO, Tomoya, Tokyo 113-8654 (JP); TANAKA, Hirokazu, Ibaraki-shi, Osaka 567-8680 (JP); NAKANISHI, Yosuke, Ibaraki-shi, Osaka 567-8680 (JP)
(74) Representative: Müller-Boré & Partner Patentanwälte PartG mbB
(86) International application number: PCT/JP2022/029862
(87) International publication number: WO 2023/013703

(57) **Abstract**

A thermoelectric conversion element 1a includes a substrate 10 and magnetic bodies 21. The magnetic bodies 21 are disposed on the substrate 10 and have ferromagnetism or antiferromagnetism. A ratio of a measured density of the magnetic bodies 21 to a theoretical density of the magnetic bodies 21 is 0.80 or more.

## Description

### TECHNICAL FIELD

The present invention relates to a thermoelectric conversion element.

### BACKGROUND ART

Thermoelectric conversion elements that utilize magnetothermoelectric effect have been known.

For instance, Patent Literature 1 describes a thermoelectric generation device utilizing anomalous Nernst effect. The anomalous Nernst effect is a phenomenon that a voltage is generated in a direction orthogonal to both the magnetization direction and the temperature gradient when a temperature difference is caused by a heat flow through a magnetic material. The thermoelectric generation device includes a substrate, a generator, and a connector. The substrate has at least a surface layer made of MgO. The generator includes a plurality of thin wires disposed parallel to each other along a surface of the substrate. The respective thin wires are made of ferromagnetic material and magnetized in the same direction. The connector includes thin wires each disposed between the thin wires in parallel to each of the thin wires of the generator. Each thin wire of the connector electrically connects one end part of each thin wire of the generator and another end part of a thin wire adjacent to one side of the first-described thin wire.

Patent Literature 2 describes a thermoelectric conversion element having a thermoelectric mechanism configured to generate an electromotive force by the anomalous Nernst effect. According to Equation (1) of Patent Literature 2, it will be understood that the Nernst coefficient Syx is in a proportional relationship with a reciprocal of electrical conductivity, that is, a specific resistance.

### CITATION LIST

### Patent Literature

[Patent Literature 1] JP 2014-072256 A
[Patent Literature 2] WO 2019/009308 A1

### SUMMARY OF INVENTION

### Technical Problem

According to the description of Patent Literature 1, a substrate having at least a surface layer made of MgO is required to form a crystal structure capable of imparting a great magnetothermoelectric effect. Namely, the technique described in Patent Literature 1 requires a special substrate. Patent Literature 1 fails to specifically consider issues for the case of producing a thermoelectric conversion element by using a non-special substrate such as a substrate including an organic material. In view of the situation, the present inventors attempted to produce a thermoelectric conversion element by using a non-special substrate such as a substrate that includes an organic material.

According to the description of Patent Literature 2, in a case of increasing the Nernst coefficient in a thermoelectric conversion element that utilizes the magnetothermoelectric effect, it is considered advantageous to increase the specific resistance of the material. On the other hand, Patent Literatures 1 and 2 fail to specifically consider problems associated with increasing the specific resistance of the material. The present inventors have studied and found that increasing the specific resistance of the material can cause problems such as noise generation and reduction in power generation output.

Taking these circumstances into consideration, the present invention provides a thermoelectric conversion element that is advantageous from the viewpoint of improving thermoelectric conversion performance even when using a non-special substrate such as a substrate including an organic material while keeping the specific resistance of the magnetic body low.

### Solution to Problem

The present invention provides a thermoelectric conversion element including:
a substrate; and
a magnetic body disposed on the substrate and having ferromagnetism or antiferromagnetism,
wherein a ratio of a measured density of the magnetic body to a theoretical density of the magnetic body is 0.80 or more.

### Advantageous Effects of Invention

The above-described thermoelectric conversion element is advantageous from the viewpoint of improving thermoelectric conversion performance even when using a non-special substrate such as a substrate including an organic material, while keeping the specific resistance of the magnetic body low.

### BRIEF DESCRIPTION OF DRAWINGS

FIG. 1 is a perspective view showing an example of thermoelectric conversion element according to the present invention.
FIG. 2 is a cross-sectional view of the thermoelectric conversion element in FIG. 1, taken on a plane II as the cross section.

### DESCRIPTION OF EMBODIMENTS

Hereinafter, embodiments of the present invention will be described with reference to the attached drawings. It should be noted that the present invention is not limited to the following embodiments.

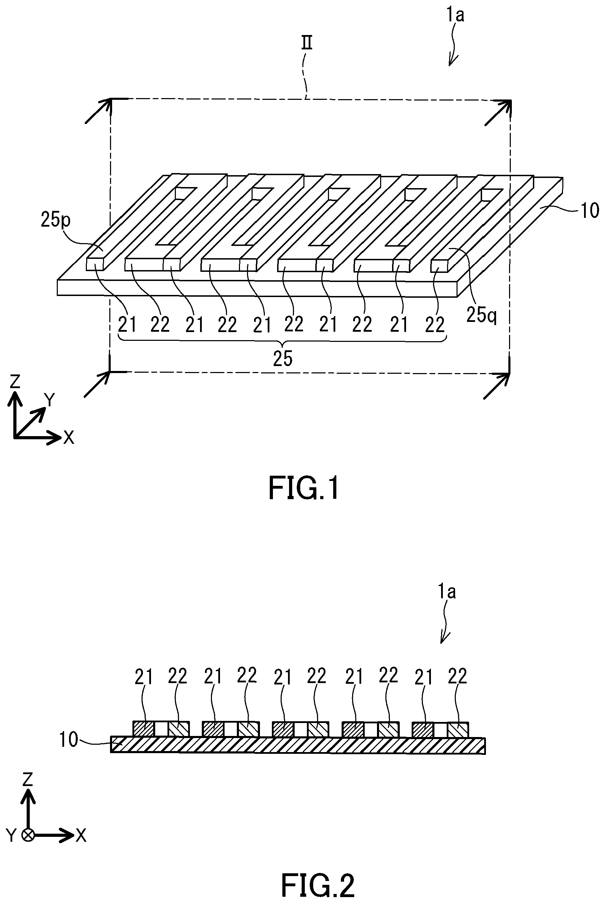

As shown in FIG. 1, a thermoelectric conversion element 1a includes a substrate 10 and magnetic bodies 21. The magnetic bodies 21 are disposed on the substrate 10 and have ferromagnetism or antiferromagnetism. A ratio D/D₀ of a measured density D of the magnetic bodies 21 to a theoretical density D₀ of the magnetic bodies 21 is 0.80 or more. By adjusting the ratio D/D₀ to this range, in the thermoelectric conversion element 1a, the thermoelectric conversion performance can be improved easily while the specific resistance of the magnetic bodies 21 is kept low. Since the specific resistance of the magnetic bodies 21 is kept low, noise generation in the thermoelectric conversion element 1a is easily prevented or reduced. In addition, the power generation output of the thermoelectric conversion element 1a can be increased easily. The theoretical density D₀ and the measured density D of the magnetic bodies 21 can be determined, for instance, according to the method described in Examples. In FIGs. 1 and 2, the X-axis, the Y-axis and the Z-axis are orthogonal to each other, and the Z-axis direction is the thickness direction of the substrate 10.

The ratio D/D₀ in the magnetic bodies 21 may be 0.82 or more, may be 0.84 or more, may be 0.90 or more, may be 0.95 or more, or may be 1.00 or more. The ratio D/D₀ in the magnetic bodies 21 is, for instance, 1.1 or less.

The magnetic bodies 21 are not limited to a specific material as long as the ratio D/D₀ in the magnetic bodies 21 is 0.80 or more. The magnetic bodies 21 generate an electromotive force in a direction orthogonal to the thickness direction (Z-axis direction) of the substrate 10, for instance, when a temperature gradient VT occurs in the thickness direction of the substrate 10. As a result, unlike a thermoelectric conversion element that utilizes the Seebeck effect for instance, it is unnecessary for the thermoelectric conversion element 1a to be thick in order to increase the power generated by the temperature gradient in the thermoelectric conversion element 1a. For instance, by increasing the dimension of the magnetic bodies 21 in a specific direction along the principal surface of the substrate 10, the electric power generated by the temperature gradient VT in the thermoelectric conversion element 1a can be increased. Therefore, the thickness of the thermoelectric conversion element 1a can be decreased easily.

The magnetic bodies 21 generate an electromotive force by, for instance, the magnetothermoelectric effect. The magnetothermoelectric effect is, for instance, anomalous Nernst effect or spin Seebeck effect. As a result, even if the thickness of the thermoelectric conversion element 1a is decreased, the electric power generated by the temperature gradient in the thermoelectric conversion element 1a may increase easily.

The magnetic bodies 21 contain, for instance, a substance expressing the anomalous Nernst effect. The substance expressing the anomalous Nernst effect is not limited to a particular substance. The substance expressing the anomalous Nernst effect is, for instance, a magnetic substance having saturation magnetization of 5 × 10⁻³ T or more, or a substance of a band structure with a Weyl point near the Fermi energy. The magnetic bodies 21 contain, for instance, at least one substance selected from the group consisting of (i), (ii), (iii), (iv) and (v) below, as a substance expressing the anomalous Nernst effect.
(i) A stoichiometric substance having a composition represented by Fe₃X
(ii) An off-stoichiometric substance having a composition ratio of Fe and X that deviates from that of the substance in (i) above
(iii) A substance in which a part of the Fe site of the substance in (i) above or a part of the Fe site in the substance in (ii) above is substituted by a typical metal element or a transition element other than X
(iv) A substance having a composition represented by Fe₃M1₁₋ₓM2ₓ (0 < x < 1), where M1 and M2 are typical elements different from each other
(v) A substance in which a part of the Fe site of the substance in (i) above is substituted by a transition element other than X, and a part of the X site in the substance in (i) above is substituted by a typical metal element other than X

In the substances (i) to (v), X is a typical element or a transition element. X is, for instance, Al, Ga, Ge, Sn, Si, Ti, Zr, Hf, V, Nb, Ta, Cr, Mo, W, Sc, Ni, Mn, or Co. In the above (iv), the combination of M1 and M2 is not limited to a specific combination as long as M1 and M2 are typical elements different from each other. In the above (iv), the combination of M1 and M2 is, for instance, Ga and Al, Si and Al, or Ga and B.

The magnetic bodies 21 may contain Co₂MnGa or Mn₃Sn as a substance expressing the anomalous Nernst effect.

As shown in FIGs. 1 and 2, the magnetic bodies 21 are shaped like rectangular parallelepipeds that are elongated in a specific direction (Y-axis direction) extending along the principal surface of the substrate 10, for instance. The magnetic bodies 21 are magnetized, for instance, in the X-axis negative direction. In a case where a temperature gradient occurs in the thickness direction of the substrate 10 and a heat flow occurs in the Z-axis positive direction, an electromotive force is generated in the positive direction of the Y-axis that is orthogonal to the Z-axis and the X-axis according to the magnetothermoelectric effect. As described above, the dimension of the magnetic bodies 21 in the Y-axis direction is greater than the dimensions of the magnetic bodies 21 in the Z-axis and the Y-axis, and thus, the electromotive force generated by the magnetothermoelectric effect tends to increase. As a result, even if the magnetic bodies 21 are not so thick, the electromotive force generated in the thermoelectric conversion element 1a tends to increase.

As shown in FIG. 1, the thermoelectric conversion element 1a includes, for instance, a conductive path 25. The conductive path 25 includes the magnetic bodies 21 and forms a meander pattern. As a result, the length of the conductive path 25 tends to increase, so that the electromotive force generated in the thermoelectric conversion element 1a tends to increase. For instance, by connecting a wiring to one end part 25p and another end part 25q of the conductive path 25, it is possible to extract the electromotive force generated in the thermoelectric conversion element 1a to the outside. Alternatively, heat flow can be generated in the thickness direction of the substrate 10 by applying a voltage between the one end part 25p and the other end part 25q.

As shown in FIG. 1, the conductive path 25 includes a plurality of magnetic bodies 21. These magnetic bodies 21 are disposed, for instance, at predetermined intervals in the X-axis direction and parallel to each other. For instance, the magnetic bodies 21 are disposed at equal intervals in the X-axis direction. The conductive path 25 further includes a plurality of connectors 22, for instance. The connectors 22 electrically connect the magnetic bodies 21 adjacent to each other in the X-axis direction. The connectors 22 electrically connect, for instance, one end part in the Y-axis direction of each magnetic body 21 and the other end part in the Y-axis direction of another magnetic body 21 adjacent to the first-described magnetic body 21 having one end part. According to this structure, the magnetic bodies 21 are electrically connected in series, whereby the electromotive force generated at the thermoelectric conversion element 1a tends to increase. One end part in the Y-axis direction of each of the magnetic bodies 21 is located at the end part of the same side in the Y-axis direction of the magnetic bodies 21, and the other end part in the Y-axis direction of each the magnetic bodies 21 is located at the end part opposite to the one end part in the Y-axis direction of the magnetic bodies 21.

As shown in FIG. 1, connectors 22 are shaped like rectangular parallelepipeds elongated in the Y-axis direction, for instance. As long as the connectors 22 are capable of electrically connecting the magnetic bodies 21 adjacent to each other, the material for forming the connectors 22 is not limited to any particular materials. The connectors 22 may contain a substance that generates an electromotive force by the magnetothermoelectric effect, for instance, and it may have ferromagnetism or antiferromagnetism. In this case, the connectors 22 are magnetized in the X-axis positive direction, for instance. Thereby, in a case where a temperature gradient occurs in the thickness direction of the substrate 10 and a heat flow is caused in the Z-axis positive direction, an electromotive force is generated in the negative direction of the Y-axis orthogonal to the Z-axis and the X-axis. Thereby, the electromotive force generated in the thermoelectric conversion element 1a tends to increase. The connectors 22 may include a non-magnetic material. In this case, the material for forming the connectors 22 is, for instance, a transition element with paramagnetism. The non-magnetic material included in the connectors 22 is, for instance, gold, copper, copper alloy, aluminum, or aluminum alloy. The connectors 22 can be a cured product of an electroconductive paste.

The substrate 10 is not limited to a specific substrate as long as the ratio D/D₀ in the magnetic bodies 21 is 0.80 or more. The substrate 10 has flexibility, for instance. Therefore, it is possible to dispose the thermoelectric conversion element 1a along the curved surface. The substrate 10 has elasticity for instance, therefore when a stripshaped specimen made of the substrate 10 is wrapped around a cylindrical mandrel with a diameter of 10 cm so that the longitudinal both ends of the specimen will point in the same direction, the specimen can be elastically deformed. Alternatively, the substrate 10 may be a non-flexible material such as a glass substrate.

In a case where the substrate 10 has flexibility, the substrate 10 include at least an organic polymer, for instance. This may facilitate reducing costs for manufacturing the thermoelectric conversion element 1a. Examples of the organic polymer include polyethylene terephthalate (PET), polyethylene naphthalate (PEN), acrylic resin (PMMA), polycarbonate (PC), polyimide (PI), and cycloolefin polymer (COP).

As long as the ratio D/D₀ in the magnetic bodies 21 is 0.80 or more, the glass transition temperature Tg of the substrate 10 is not limited to a specific value. The glass transition temperature Tg of the substrate 10 is, for instance, 200°C or lower. Since it is possible to adopt a relatively low temperature condition as the condition for forming the magnetic bodies 21 on the substrate 10, a material having a glass transition temperature Tg of 200°C or lower can be used for the substrate. This can decrease easily the energy required for production of the thermoelectric conversion element 1a. In addition, by using the material having a glass transition temperature Tg of 200°C or lower for the substrate 10, for instance, in a case of forming the magnetic bodies 21 as a sputtered film, the sputtered material will be diffused easily into the substrate 10. As a result, the adhesiveness between the substrate 10 and the magnetic bodies 21 tends to increase.

The glass transition temperature Tg of the substrate 10 may be 180°C or lower, may be 150°C or lower, may be 120°C or lower, or may be 100°C or lower. The glass transition temperature Tg is, for instance, 50°C or higher.

As long as the ratio D/D₀ for the magnetic bodies 21 is 0.80 or more, the squareness ratio Mᵣ/Mₛ of the magnetic bodies 21 is not limited to a specific value. The squareness ratio Mᵣ/Mₛ is a ratio of a residual magnetization Mᵣ to a saturation magnetization Mₛ in a M-H curve of the magnetic bodies 21. The value of the squareness ratio Mᵣ/Mₛ is, for instance, 0.6 or more. As a result, the thermoelectric conversion element 1a exhibits a high residual magnetization in a zero magnetic field, and the power generation output of the thermoelectric conversion element 1a may easily increase.

The squareness ratio Mᵣ/Mₛ of the magnetic bodies 21 may be 0.62 or more, may be 0.63 or more, may be 0.64 or more, may be 0.65 or more, or may be 0.66 or more. The squareness ratio Mᵣ/Mₛ of the magnetic bodies 21 may be 0.7 or more, may be 0.8 or more, or may be 0.9 or more.

As long as the ratio D/D₀ in the magnetic bodies 21 is 0.80 or more, the residual magnetization Mᵣ of the magnetic bodies 21 is not limited to a specific value. The residual magnetization Mᵣ of the magnetic bodies 21 is 500 emu/cm³ or more. Therefore, the thermoelectric conversion element 1a exhibits a high magnetothermoelectric effect in the zero magnetic field, and the power generation output of the thermoelectric conversion element 1a tends to increase.

The residual magnetization Mᵣ of the magnetic bodies 21 may be 550 emu/cm³ or more, may be 600 emu/cm³ or more, may be 650 emu/cm³ or more, may be 700 emu/cm³ or more, or may be 800 emu/cm³ or more. The residual magnetization Mᵣ of the magnetic bodies 21 may be 900 emu/cm³ or more, may be 1000 emu/cm³ or more, may be 1200 emu/cm³ or more, may be 1300 emu/cm³ or more, or may be 1400 emu/cm³ or more. The residual magnetization Mᵣ of the magnetic bodies 21 is, for instance, 2000 emu/cm³ or less. The residual magnetization Mᵣ of the magnetic bodies 21 may be 1900 emu/cm³ or less, may be 1800 emu/cm³ or less, may be 1700 emu/cm³ or less, may be 1600 emu/cm³ or less, or 1500 emu/cm³ or less.

As long as the ratio D/D₀ in the magnetic bodies 21 is 0.80 or more, a maximum value of a slope of the M-H curve of the magnetic bodies 21 is not limited to a specific value. The maximum value of the slope of the M-H curve of the magnetic bodies 21 is, for instance, 1.5 emu/(cm³ × Oe) or more. This allows the thermoelectric conversion element 1a to exhibit a high residual magnetization in the zero magnetic field, and the power generation output of the thermoelectric conversion element 1a tends to increase. The maximum value of the slope of the M-H curve of the magnetic bodies 21 may be 5 emu/(cm³ × Oe) or more, may be 10 emu/(cm³ × Oe) or more, may be 20 emu/(cm³ × Oe) or more, or may be 50 emu/(cm³ × Oe) or more.

The magnetic body 21 forms a film, for instance. As long as the ratio D/D₀ in the magnetic bodies 21 is 0.80 or more, the magnetic body 21 is not limited to a specific film. The magnetic body 21 forms a sputtered film, for instance. This makes it easier for the magnetic bodies 21 to be formed as a dense film in the thermoelectric conversion element 1a, making it easier to more reliably prevent or reduce noise generation and making it easier to increase the power generation output of the thermoelectric conversion element 1a. The magnetic bodies 21 may be a film other than a sputtered film. The magnetic bodies 21 may be, for instance, a vapor deposited film or a plated film. The magnetic bodies 21 may be, for instance, a non-sintered material.

As long as the ratio D/D₀ in the magnetic bodies 21 is 0.80 or more, the thickness of the substrate 10 is not limited to a specific value. The thickness of the substrate 10 is, for instance, 200 µm or less. Thereby, the thermal resistance of the thermoelectric conversion element 1a in the thickness direction of the substrate 10 is likely to be lowered.

The thickness of the substrate 10 may be 190 µm or less, may be 180 µm or less, may be 170 µm or less, or may be 160 µm or less. The thickness of the substrate 10 may be 150 µm or less, may be 140 µm or less, may be 130 µm or less, may be 120 µm or less, or may be 110 µm or less. The thickness of the substrate 10 may be 100 µm or less, may be 90 µm or less, may be 80 µm or less, may be 70 µm or less, or may be 60 µm or less. The thickness of the substrate 10 is, for instance, 10 µm or more. This may facilitate transporting the substrate 10, and the substrate 10 may easily have a desired handling property. The thickness of the substrate 10 may be 20 µm or more, or may be 30 µm or more.

As long as the ratio D/D₀ in the magnetic bodies 21 is 0.80 or more, the thickness of the magnetic bodies 21 is not limited to a specific value. The magnetic bodies 21 have a thickness of, for instance, 1000 nm or less. Thereby, use amount of the material for forming the magnetic bodies 21 in the thermoelectric conversion element 1a can be reduced, and the costs for manufacturing the thermoelectric conversion element 1a can be reduced easily. In addition to that, disconnection of conductive path 25 in the thermoelectric conversion element 1a is less likely to occur.

Thickness of the magnetic bodies 21 may be 750 nm or less, may be 500 nm or less, may be 400 nm or less, may be 300 nm or less, or may be 200 nm or less. The thickness of the magnetic bodies 21 is, for instance, 10 nm or more. Thereby, the thermoelectric conversion element 1a can easily exhibit high durability. The thickness of the magnetic bodies 21 may be 20 nm or more, may be 30 nm or more, or may be 50 nm or more.

As long as the ratio D/D₀ in the magnetic bodies 21 is 0.80 or more, a width as the minimum dimension in the X-axis direction of each magnetic body 21 is not limited to a particular value. The width of each magnetic body 21 is, for instance, 500 µm or less. Thereby, use amount of the material for forming the magnetic bodies 21 in the thermoelectric conversion element 1a can be reduced, and the costs for manufacturing the thermoelectric conversion element 1a can be reduced easily. In addition to that, numbers of magnetic bodies 21 can be disposed easily in the X-axis direction, whereby the electromotive force generated in the thermoelectric conversion element 1a may easily increase.

The width of each magnetic body 21 may be 400 µm or less, may be 300 µm or less, may be 200 µm or less, may be 100 µm or less, or may be 50 µm or less. The width of each magnetic body 21 is, for instance, 0.1 µm or more. Thereby, disconnection of the conductive path 25 in the thermoelectric conversion element 1a is less likely to occur, and the thermoelectric conversion element 1a can easily exhibit high durability. The width of each magnetic body 21 may be 0.5 µm or more, may be 1 µm or more, may be 2 µm or more, may be 5 µm or more, may be 10 µm or more, may be 20 µm or more, may be 30 µm or more, or may be 50 µm or more.

As long as the connectors 22 can electrically connect the magnetic bodies 21 adjacent to each other, the thickness of the connectors 22 is not limited to any particular value. The thickness of the connectors 22 is, for instance, 1000 nm or less. Thereby, the use amount of the material for forming the connectors 22 can be reduced, and the costs for manufacturing the thermoelectric conversion element 1a can be reduced easily. In addition to that, disconnection of the conductive path 25 is less likely to occur in the thermoelectric conversion element 1a. The thickness of the connectors 22 may be 750 nm or less, may be 500 nm or less, may be 400 nm or less, may be 300 nm or less, or may be 200 nm or less.

The thickness of the connectors 22 is, for instance, 5 nm or more. Thereby, the thermoelectric conversion element 1a can easily exhibit high durability. The thickness of the connectors 22 may be 10 nm or more, may be 20 nm or more, may be 30 nm or more, or may be 50 nm or more.

As long as the connectors 22 can electrically connect the magnetic bodies 21 adjacent to each other, a width as the minimum dimension in the X-axis direction of each connector 22 is not limited to any particular value. The width of each connector 22 is, for instance, 500 µm or less. Thereby, use amount of the material for forming the connectors 22 in the thermoelectric conversion element 1a can be reduced, and the costs for manufacturing the thermoelectric conversion element 1a can be reduced easily. In addition to that, numbers of magnetic bodies 21 can be disposed easily in the X-axis direction, whereby the electromotive force generated in the thermoelectric conversion element 1a tends to increase.

The width of each connector 22 may be 400 µm or less, may be 300 µm or less, may be 200 µm or less, may be 100 µm or less, or may be 50 µm or less. The width of each connector 22 is, for instance, 0.1 µm or more. Thereby, disconnection of the conductive path 25 in the thermoelectric conversion element 1a is less likely to occur, and the thermoelectric conversion element 1a can easily exhibit high durability. The width of each connector 22 may be 0.5 µm or more, may be 1 µm or more, may be 2 µm or more, may be 5 µm or more, may be 10 µm or more, may be 20 µm or more, or may be 30 µm or more.

An example of the method for manufacturing the thermoelectric conversion element 1a will be explained. First, a thin film of a precursor for the magnetic bodies 21 is formed on one principal surface of the substrate 10 by any method such as sputtering, chemical vapor deposition (CVD), pulsed laser deposition (PLD), ion plating, plating or the like. Next, a photoresist is applied onto the thin film, a photomask is disposed on the thin film and exposed, followed by wet etching. In this manner, linear patterns of the precursor for a plurality of magnetic bodies 21 disposed at predetermined intervals are formed. Next, a thin film of a precursor for the connectors 22 is formed on the principal surface of substrate 10 by any method such as sputtering, CVD, PLD, ion plating, or plating. Next, a photoresist is applied onto the thin film of the precursor for connectors 22, a photomask is disposed on the thin film of the precursor for connectors 22 and exposed, followed by wet etching. Connectors 22 are obtained in this manner, and the linear patterns of the precursor for the magnetic bodies 21 are electrically connected to each other. Next, the precursor for the magnetic bodies 21 is magnetized to form the magnetic bodies 21. In this manner, the thermoelectric conversion element 1a is obtained. As required, the connectors 22 may be formed by magnetizing the precursor for the connectors 22.

By adjusting the requirements for forming the thin film of the precursor of the magnetic bodies 21, the ratio D/D₀ in the magnetic bodies 21 can be adjusted to the desired range. For instance, when forming the thin film of the precursor of the magnetic bodies 21 by sputtering, the pressure of the atmosphere for sputtering of the substrate 10 and the distance between the substrate 10 and the target material are adjusted, so that the ratio D/D₀ in the magnetic bodies 21 can be adjusted to the desired range.

When forming a thin film of the precursor of the magnetic bodies 21 by sputtering, the pressure of the atmosphere for sputtering of the substrate 10 is not limited to a specific value as long as the ratio D/D₀ in the magnetic bodies 21 is 0.80 or more. The pressure may be, for instance, 2.5 Pa or less, or may be 2.0 Pa or less. The pressure is preferably 0.5 Pa or less. As a result, even if the substrate 10 includes any organic material such as an organic polymer, the density of the magnetic bodies 21 may be increased easily, and the ratio D/D₀ easily becomes 0.80 or more. The pressure of the atmosphere around the substrate 10 for sputtering is more preferably 0.3 Pa or less, further preferably 0.2 Pa or less, particularly preferably 0.1 Pa or less. Further, the pressure is preferably 0.05 Pa or more. Thereby, even when the target is a magnetic body, discharge is likely to occur and a thin film can be stably formed.

When forming a thin film of the precursor of the magnetic bodies 21 by sputtering, a TS distance, which is the distance between the target material and the substrate 10, is not limited to a specific value as long as the ratio D/D₀ in the magnetic bodies 21 is 0.80 or more. The TS distance is, for instance, 120 mm or less. In this case, even if the substrate 10 includes an organic material such as an organic polymer, the density of the magnetic bodies 21 tends to be high, and the ratio D/D₀ tends to be 0.80 or more. The TS distance is preferably 100 mm or less, more preferably 80 mm or less, and even more preferably 60 nm or less. The TS distance is, for instance, 40 mm or more. As a result, discharge is likely to occur even if the target is a magnetic body, whereby a thin film can be formed stably.

When forming a thin film of the precursor of the magnetic bodies 21 by sputtering, the magnetic field is not limited to a specific value as long as the ratio D/D₀ in the magnetic bodies 21 is 0.80 or more. The magnetic field is, for instance, 150 mT or less. In this case, even if the substrate 10 includes an organic material such as an organic polymer, the density of the magnetic bodies 21 tends to be increased and the ratio D/D₀ is likely to be 0.80 or more. The magnetic field is, for instance, 30 mT or more. In this case, even if the target is a magnetic body, discharge is likely to occur and a thin film can be formed stably.

The thermoelectric conversion element 1a can be provided, for instance, together with a pressure-sensitive adhesive layer. In this case, the substrate 10 is disposed between the magnetic bodies 21 and the pressure-sensitive adhesive layer in the thickness direction of the substrate 10. Thereby, it is possible to attach the thermoelectric conversion element 1a to an article by pressing the pressure-sensitive adhesive layer onto the article.

The pressure-sensitive adhesive layer includes, for instance, a rubber-based pressure-sensitive adhesive, an acrylic pressure-sensitive adhesive, a silicone-based pressure-sensitive adhesive, or a urethane-based pressure-sensitive adhesive. The thermoelectric conversion element 1a may be provided together with a pressure-sensitive adhesive layer and a separator. In this case, the separator covers the pressure-sensitive adhesive layer. Typically, the separator is a film that can maintain the adhesiveness of the pressure-sensitive adhesive layer while covering the layer, and it can be peeled off easily from the pressure-sensitive adhesive layer. The separator is, for instance, a film made of a polyester resin like PET By peeling the separator off, the pressure-sensitive adhesive layer is exposed and the thermoelectric conversion element 1a can be adhered to an article.

### EXAMPLES

Hereinafter, the present invention will be described in detail by referring to Examples. It should be noted that the present invention is not limited to the following Examples. First, evaluation methods regarding Examples and Comparative Examples will be explained.

### [Theoretical density]

Using an X-ray diffractometer SmartLab manufactured by Rigaku Corporation, a Cu-Kα ray was irradiated onto a sample made of a magnetic body of the thermoelectric conversion element according to each Example and each Comparative Example, and an XRD pattern of crystal of the magnetic body was obtained. From the peak position of the obtained XRD pattern, an interplanar distance d of the crystal of the magnetic body was determined based on the relationship: 2dsinθ = λ. Here, 2θ is the peak position of the XRD pattern, and λ is 0.1541 nm, namely, the wavelength of the Cu-Kα ray. The lattice constant a of the crystal was determined from the value of the interplanar distance d. In this determination, the Miller index of the crystal was (001).

Using an X-ray fluorescence spectrometer ZSX Primus III+ manufactured by Rigaku Corporation, an elemental composition of the sample made of the magnetic body of the thermoelectric conversion element according to each Example and each Comparative Example was measured. Through this measurement, Fe and Ga in the sample were detected. From this measurement result, the mole fraction x of Fe in the magnetic body was determined. Furthermore, the apparent atomic mass M [g/mol] of the magnetic body was determined based on the relationship: M = 55.85 [g/mol] × x + 69.72 [g/mol] × (1-x), with reference to the atomic mass of Fe of 55.85 [g/mol] and the atomic mass of Ga of 69.72 [g/mol]. Further, the theoretical density D₀ of the magnetic body was determined based on the relationship: D₀ = (N × M)/a³, using the number N of atoms in the unit cell of the crystal structure N, the apparent atomic mass M of the magnetic body, and the value of the lattice constant a of the crystal, where the number N was specified from the results of the aforementioned XRD. The results are shown in Table 2.

### [Measured density]

An X-ray reflectance profile of the magnetic body was obtained using an X-ray diffractometer SmartLab manufactured by Rigaku Corporation, with regard to a sample made of a magnetic body in a thermoelectric conversion element according to each Example and each Comparative Example and in accordance with an X-ray reflectivity (XRR). The measured density D of the magnetic body was determined by fitting from the obtained X-ray reflectance profile. The results are shown in Table 2. Table 2 shows also the ratio D/D₀ of the measured density D to the theoretical density D₀ of the magnetic body of the thermoelectric conversion element according to each Example and each Comparative Example.

### [Specific resistance]

Using a non-contact type resistance measuring instrument NC-80LINE manufactured by NAPSON CORPORATION, a sheet resistance of the magnetic body of the thermoelectric conversion element related to each Example and each Comparative Example was measured by the eddy current method in accordance with Japanese Industrial Standard (JIS) Z 2316. The thickness of the magnetic body of the thermoelectric conversion element according to each Example and each Comparative Example was determined from the aforementioned XRR measurement results. In each Example and each Comparative Example, the specific resistance of the magnetic body was determined from the sheet resistance and thickness of the magnetic body. The results are shown in Table 2.

### [Terminal resistance]

The electrical resistance value between both ends of the conductive path forming a meander pattern in the thermoelectric conversion elements according to each Example and each Comparative Example was measured. The results are shown in Table 2.

### [Magnetic property]

Using a physical property measurement system PPMS-versalab supplied by Quantum Design Inc., the magnetic property of the magnetic body of the thermoelectric conversion element in each Example and each Comparative Example was measured. For this measurement, a measurement sample, which was produced by cutting a thermoelectric conversion element according to each Example and each Comparative Example into 2 mm square pieces, was used. In the measurement, further a Vibration Sample Magnetrometer (VSM) was used to sweep a magnetic field of ±10000[Oe] under a condition of a temperature of 300K, so that a saturation magnetization Ms and a residual magnetization Mr of the magnetic body were determined considering the thickness of the magnetic body determined from the XRR measurement results and the area of the magnetic body in the measurement sample. In the M-H curve of a magnetic body, the magnetic moment of the magnetic body at a magnetic flux density of 1 T was determined as the saturation magnetization Ms of the magnetic body, and the magnetic moment of the magnetic body at a magnetic flux density of 0 T was determined as the residual magnetization Mr of the magnetic body. In addition, a ratio Mr/Ms of the residual magnetization Mr to the saturation magnetization Ms was determined as the squareness ratio. The results are shown in Table 2.

### [Thermoelectric property]

The thermoelectric conversion element according to each Example and each Comparative Example was fixed between a pair of Cu plates with dimensions of 30 mm, 30 mm, and 5 mm, using silicone grease KS609 manufactured by Shin-Etsu Chemical Co., Ltd., thereby producing a sample for thermoelectric property evaluation. This sample was placed on a cool plate SCP-125 supplied by AS ONE Corporation. A film heater manufactured by Shinwa Rules Co., Ltd. was fixed on the upper Cu plate with a double-sided tape No. 5000NS manufactured by Nitto Denko Corporation. This heater had dimensions of 30 mm square and an electrical resistance value of 20 Ω. While the temperature of the cool plate was maintained at 25°C, the film heater was made generate heat under a constant voltage control of 10 V, and the amount of heat output from the film heater was adjusted to 0.52 W/cm². At this time, the electromotive force generated in the thermoelectric conversion element was measured using a data logger, and the value of the electromotive force in a steady state was read. Also, the noise and the S/N ratio were obtained from the measurement results by the data logger. The results are shown in Table 2.

### [Adhesiveness]

The adhesiveness between the substrate and the thin film formed on the substrate was evaluated with reference to the cross-cut method of JIS K 5600-5-6. Using a knife, respectively eleven cuts were formed vertically and horizontally at 1mm intervals on the thin film, thereby making a total of 100 squares in a grid pattern. A tape was brought into contact with the thin film so as to cover the 100 squares, then, by grabbing the edge of the tape, the tape was peeled off in 0.5 to 1.0 seconds in a direction to make an angle of 60° with respect to the surface of the thin film, and peeling in the 100 squares of the thin film was visually checked. If all the squares remained without being peeled off, it was evaluated as "A", and if peeling was found in at least one square, it was evaluated as "X". The results are shown in Table 2.

### EXAMPLES

### <Example 1>

A thin film having a thickness of 96 nm was formed on a polyethylene terephthalate (PET) film having a thickness of 50 µm by DC magnetron sputtering using a target material containing Fe and Ga. Table 1 shows requirements for forming the thin film. In the DC magnetron sputtering, a magnet with a magnetic flux density of 100 mT was used. The PET film had a glass transition temperature of 78°C. In this target material, the atomic ratio of the Fe content to the Ga content was in a relationship of 3:1. In the DC magnetron sputtering, the distance between the target material and the PET film was adjusted to 75 mm. In the DC magnetron sputtering, an argon gas was fed as a process gas at a pressure of 0.1 Pa. Furthermore, the temperature of the PET film was adjusted to 130°C. A photoresist was applied onto the thin film, a photomask was disposed on the thin film and exposed, followed by wet etching. Thereby, 98 FeGa-containing linear patterns aligned at predetermined intervals were formed. The width of each FeGa-containing linear pattern was 100 µm, the length of each FeGa linear pattern was 15 mm, and the total length of the FeGa linear patterns was 147 cm. After that, a Cu thin film having a thickness of 100 nm was formed by DC magnetron sputtering using a Cu-containing target material. A photoresist was applied onto the Cu thin film, a photomask was disposed on the Cu thin film and exposed, followed by wet etching. In this manner, a Cu-containing linear pattern having a width of 40 µm was formed. A pair of adjacent FeGa-containing linear patterns were electrically connected by the Cu-containing linear pattern, thereby forming a conductive path of a meander pattern. Using an electromagnet with a central magnetic flux density of 0.5 T, the FeGa-containing linear pattern was magnetized in a direction parallel to the plane of the PET film and orthogonal to the length direction of the FeGa-containing linear pattern, whereby a magnetic body was formed. The specific resistance of the magnetic body in Example 1 was 1.1 × 10⁻⁴ Ωcm, and the thickness of the magnetic body was 96 nm. In this way, the thermoelectric conversion element according to Example 1 was obtained. This thermoelectric conversion element generated an electromotive force by the anomalous Nernst effect.

### <Example 2>

A thermoelectric conversion element according to Example 2 was obtained in the same manner as in Example 1 except for the following points. As shown in Table 1, a glass plate was used as the substrate instead of the PET film. An argon gas was fed as the process gas at a pressure of 0.5 Pa, and the distance between the target material and the substrate was adjusted to 80 mm.

### <Example 3>

As shown in Table 1, a thermoelectric conversion element according to Example 3 was obtained in the same manner as in Example 2, except that the argon gas was fed as the process gas at a pressure of 2 Pa.

### <Example 4>

As shown in Table 1, a thermoelectric conversion element according to Example 4 was obtained in the same manner as in Example 1, except that the argon gas was fed as the process gas at a pressure of 0.5 Pa, and the distance between the target material and the substrate was adjusted to 40 mm.

### <Example 5>

As shown in Table 1, a thermoelectric conversion element according to Example 5 was obtained in the same manner as in Example 4, except that the distance between the target material and the substrate was adjusted to 60 mm.

### <Example 6>

As shown in Table 1, a thermoelectric conversion element according to Example 6 was obtained in the same manner as in Example 4, except that the distance between the target material and the substrate was adjusted to 120 mm.

### <Comparative Example 1>

A thermoelectric conversion element according to Comparative Example 1 was obtained in the same manner as in Example 2, except that the argon gas was fed as the process gas at a pressure of 3 Pa.

### <Comparative Example 2>

As shown in Table 1, a thermoelectric conversion element according to Comparative Example 2 was obtained in the same manner as in Example 4, except that the distance between the target material and the substrate was adjusted to 180 mm.

### <Comparative Example 3>

As shown in Table 1, a thermoelectric conversion element according to Comparative Example 3 was obtained in the same manner as in Example 1, except that the argon gas was fed as the process gas at a pressure of 1 Pa, and the distance between the target material and the substrate was adjusted to 80 mm.

As shown in Table 2, although the specific resistance of the thermoelectric conversion element according to each Example was lower than those of the thermoelectric conversion elements according to Comparative Examples 1 to 3, the thermoelectric conversion element according to each Example had a higher electromotive force in a steady state and had a better thermoelectric conversion property when compared to the thermoelectric conversion elements according to Comparative Examples 1 to 3. Furthermore, the thermoelectric conversion element according to each Example had lower noise and a higher S/N ratio than the thermoelectric conversion elements according to Comparative Examples 1 to 3. On the other hand, the thermoelectric conversion elements according to Comparative Examples 1 to 3 had low electromotive force in a steady state, namely, it was difficult to note that these thermoelectric conversion elements had favorable thermoelectric conversion property. Furthermore, the thermoelectric conversion elements according to Comparative Examples 1 to 3 had large noise and small S/N ratios.

As shown in Table 2, the value of the ratio D/D₀ of the magnetic body of the thermoelectric conversion element according to each Example was 0.80 or more. On the other hand, the ratios D/D₀ of the magnetic bodies of the thermoelectric conversion elements according to Comparative Examples 1 to 3 were less than 0.80. It was suggested that the ratio D/D₀ of 0.80 or more in the magnetic bodies is advantageous in improving the thermoelectric conversion property of the thermoelectric conversion element.

As shown in Table 2, the saturation magnetization Ms, the residual magnetization Mr, and squareness ratio Mr/Ms of the magnetic body of the thermoelectric conversion element according to each Example are higher than those of the magnetic body of the thermoelectric conversion element according to Comparative Example 1. It was suggested that since the ratio D/D₀ in the magnetic body is 0.80 or more, the magnetic property of the thermoelectric conversion element can be easily improved.

As shown in Table 2, the evaluation for adhesiveness was "A" in Examples 1, 3 to 4 and Comparative Examples 2 and 3, whereas the evaluation for adhesiveness was "X" in Examples 2 and 3 and Comparative Example 1. This suggests that a substrate of PET tends to increase the adhesiveness between the substrate and a thin film formed on the substrate when compared to a case where the substrate is glass.

A first aspect of the present invention provides a thermoelectric conversion element including:
a substrate; and
a magnetic body disposed on the substrate and having ferromagnetism or antiferromagnetism,
wherein a ratio of a measured density of the magnetic body to a theoretical density of the magnetic body is 0.80 or more.

A second aspect of the present invention provides a thermoelectric conversion element according to the first aspect, wherein the substrate of the thermoelectric conversion element has flexibility.

A third aspect of the present invention provides a thermoelectric conversion element according to the second aspect, wherein the substrate of the thermoelectric conversion element includes at least an organic polymer.

A fourth aspect of the present invention provides a thermoelectric conversion element according to any one of the first to third aspects, wherein the substrate of the thermoelectric conversion element has a glass transition temperature of 200°C or lower.

A fifth aspect of the present invention provides a thermoelectric conversion element according to any one of the first to fourth aspects, wherein a squareness ratio, which is the ratio of a residual magnetization to a saturation magnetization in an M-H curve of the magnetic body in the thermoelectric conversion element, is 0.6 or more.

A sixth aspect of the present invention provides a thermoelectric conversion element according to any one of the first to fifth aspects, wherein the residual magnetization of the magnetic body of the thermoelectric conversion element is 500 emu/cm³ or more.

A seventh aspect of the present invention provides a thermoelectric conversion element according to any one of the first to sixth aspects, wherein a maximum value of a slope of an M-H curve of the magnetic body of the thermoelectric conversion element is 1.5 emu/(cm³ × Oe) or more.

An eighth aspect of the present invention provides a thermoelectric conversion element according to any one of the first to seventh aspects, wherein the magnetic body of the thermoelectric conversion element is a sputtered film.

A ninth aspect of the present invention provides a thermoelectric conversion element according to any one of the first to eighth aspects, wherein the thermoelectric conversion element generates an electromotive force in a direction orthogonal to the thickness direction of the substrate when a temperature gradient occurs in the thickness direction of the substrate.

A tenth aspect of the present invention provides a thermoelectric conversion element according to any one of the first to ninth aspects, wherein the magnetic body of the thermoelectric conversion element is capable of generating an electromotive force by abnormal Nernst effect.

An eleventh aspect of the present invention provides a thermoelectric conversion element according to any one of the first to tenth aspects, wherein the thermoelectric conversion element includes a conductive path including the magnetic body and forming a meander pattern.

**[Table 1]**

| | Substrate | | Film formation requirement | | | |
|---|---|---|---|---|---|---|
| | Material | T_{g} [°C] | Film formation temp. [°C] | Gas pressure [Pa] | TS distance [mm] | Magnetic field [mT] |
| Example 1 | PET | 78 | 130 | 0.1 | 75 | 100 |
| Example 2 | Glass | - | 130 | 0.5 | 80 | 100 |
| Example 3 | Glass | - | 130 | 2 | 80 | 100 |
| Example 4 | PET | 78 | 130 | 0.5 | 40 | 100 |
| Example 5 | PET | 78 | 130 | 0.5 | 60 | 100 |
| Example 6 | PET | 78 | 130 | 0.5 | 120 | 100 |
| Comparative Example 1 | Glass | - | 130 | 3 | 80 | 100 |
| Comparative Example 2 | PET | 78 | 130 | 0.5 | 180 | 100 |
| Comparative Example 3 | PET | 78 | 130 | 1 | 80 | 100 |

**[Table 2]**

| | Theoretical density of magnetic body D₀ [g/cm³] | Measured density of magnetic body D [g/cm³] | D/D₀ | Thickness of magnetic body [nm] | Sheet resistance of magnetic body [Ω/□] | Specific resistance of magnetic body [Ω cm] | | |
|---|---|---|---|---|---|---|---|---|
| Example 1 | 7.88 | 8.09 | 1.03 | 96 | 9.9 | 1.1×10⁻⁴ | | |
| Example 2 | 7.99 | 7.82 | 0.98 | 82 | 11.9 | 9.7×10⁻⁵ | | |
| Example 3 | 8.12 | 6.83 | 0.84 | 90 | 40.3 | 3.6×10⁻⁴ | | |
| Example 4 | 8.11 | 7.81 | 0.96 | 92 | 12 | 1.1×10⁻⁴ | | |
| Example 5 | 8.09 | 7.62 | 0.94 | 78 | 16.7 | 1.3×10⁻⁴ | | |
| Example 6 | 8.17 | 7.19 | 0.88 | 87 | 29.9 | 2.6×10⁻⁴ | | |
| Comparative Example 1 | 8.28 | 6.35 | 0.77 | 86 | 60.2 | 5.3×10⁻⁴ | | |
| Comparative Example 2 | 8.17 | 6.23 | 0.76 | 94 | 63 | 5.9×10⁻⁴ | | |
| Comparative Example 3 | 8.15 | 5.96 | 0.73 | 88 | 69.3 | 6.1×10⁻⁴ | | |

**[Table 2] (Continued)**

| | Magnetic property | | | | Thermoelectric property | | | Adhesiveness |
|---|---|---|---|---|---|---|---|---|
| | Remanent magnetization Mr [emu/cm³] | Saturation magnetization Ms [emu/cm³] | Square -ness ratio Mr/Ms | Maximum slope of M-H curve [emu/ (cm³ × Oe)] | Steady state electromotive force [mV] | Noise [mV] | S/N ratio | Cross cut test |
| Example 1 | 876 | 1356 | 0.65 | 51.6 | 1.47 | 0.12 | 12.4 | A |
| Example 2 | 990 | 1501 | 0.73 | 135 | 1.39 | 0.11 | 13.1 | X |
| Example 3 | 528 | 790 | 0.68 | 1.52 | 1.47 | 0.19 | 7.9 | X |
| Example 4 | 942 | 1286 | 0.73 | 50.1 | 1.45 | 0.13 | 11.0 | A |
| Example 5 | 916 | 1224 | 0.75 | 49.2 | 1.38 | 0.16 | 8.9 | A |
| Example 6 | 738 | 938 | 0.79 | 38.1 | 1.35 | 0.21 | 6.5 | A |
| Comparative Example 1 | 490 | 861 | 0.58 | 1.49 | 0.74 | 0.40 | 1.9 | X |
| Comparative Example 2 | 437 | 875 | 0.50 | 1.29 | 0.63 | 0.30 | 2.1 | A |
| Comparative Example 3 | 421 | 729 | 0.58 | 1.12 | 0.45 | 0.32 | 1.4 | A |

## Claims

1. A thermoelectric conversion element comprising:
a substrate; and
a magnetic body disposed on the substrate and having ferromagnetism or antiferromagnetism,
wherein a ratio of a measured density of the magnetic body to a theoretical density of the magnetic body is 0.80 or more.

2. The thermoelectric conversion element according to claim 1, wherein the substrate has flexibility.

3. The thermoelectric conversion element according to claim 2, wherein the substrate comprises at least an organic polymer.

4. The thermoelectric conversion element according to claim 1, wherein the substrate has a glass transition temperature of 200°C or lower.

5. The thermoelectric conversion element according to claim 1, wherein a squareness ratio of the magnetic body is 0.6 or more, the squareness ratio being a ratio of a residual magnetization to a saturation magnetization in an M-H curve of the magnetic body.

6. The thermoelectric conversion element according to claim 1, wherein a residual magnetization of the magnetic body is 500 emu/cm³ or more.

7. The thermoelectric conversion element according to claim 1, wherein a maximum value of a slope of an M-H curve of the magnetic body is 1.5 emu/(cm³ × Oe) or more.

8. The thermoelectric conversion element according to claim 1, wherein the magnetic body is a sputtered film.

9. The thermoelectric conversion element according to claim 1, wherein the magnetic body generates an electromotive force in a direction orthogonal to a thickness direction of the substrate when a temperature gradient occurs in the thickness direction of the substrate.

10. The thermoelectric conversion element according to claim 1, wherein the magnetic body is capable of generating an electromotive force by anomalous Nernst effect.

11. The thermoelectric conversion element according to claim 1, comprising a conductive path comprising the magnetic body, the conductive path forming a meander pattern.
